# EUROPEAN PATENT APPLICATION

(11) **EP 4 614 175 A2**
(43) Date of publication of application: **10.09.2025**
(21) Application number: 25158457.9
(22) Date of filing: 18.02.2025
(51) Int. Cl.: G01R 33/00

(54) **MAGNETIC FIELD MEASUREMENT DEVICE**

(30) Priority: 05.03.2024 JP 2024032925
(71) Applicant: TDK Corporation, Tokyo 103-6128 (JP)
(72) Inventor: HOTTA, Yu, Tokyo, 103-6128 (JP); TERAZONO, Yasushi, Tokyo, 103-6128 (JP); SHIBUYA, Tomohiko, Tokyo, 103-6128 (JP)
(74) Representative: Epping - Hermann - Fischer

(57) **Abstract**

Disclosed herein is a magnetic field measurement device that includes a first sensor unit having one or more magnetic sensors, a second sensor unit having one or more magnetic sensors and one or more magnetic field generating coils, and a moving mechanism configured to change a relative positional relationship between the first and second sensor units.

## Description

### BACKGROUND OF THE ART

### --Field of the Art

The present disclosure relates to a magnetic field measurement device and, more particularly, to a magnetic field measurement device provided with a plurality of sensor units having a changeable relative positional relationship between one another.

### --Description of Related Art

Japanese Patent No. 7399426 discloses (FIG. 5) a magnetic field measurement device provided with two sensor units having measurement surfaces facing mutually different directions.

In the magnetic field measurement device described in Japanese Patent No. 7,399,426, the relative positional relationship between the two sensor units is fixed. However, when the relative positional relationship between a plurality of sensor units is changeable, it takes much time when calibration is performed every time the relative positional relationship between the sensor units is changed. The calibration refers to a process that uses a magnetic field generated by a reference magnetic field generator to calculate a parameter (position, direction, sensitivity, etc.) of each sensor. Further, when an object to be measured has already been disposed between the sensor units, a calibration tool cannot be disposed therebetween in the first place.

### SUMMARY

The present disclosure relates to a magnetic field measurement device provided with a plurality of sensor units having a changeable relative positional relationship between one another and describes a technology capable of easily identifying the relative positional relationship between the plurality of sensor units even after the relative positional relationship therebetween is changed.

A magnetic field measurement device according to an aspect of the present disclosure includes: a first sensor unit having one or more magnetic sensors; a second sensor unit having one or more magnetic sensors and one or more magnetic field generating coils; and a moving mechanism for changing the relative positional relationship between the first and second sensor units.

According to the present disclosure, there can be provided a technology capable of, in a magnetism measurement device provided with a plurality of sensor units having a changeable relative positional relationship between one another, easily identifying the relative positional relationship between the plurality of sensor units even after the relative positional relationship therebetween is changed.

### BRIEF DESCRIPTION OF THE DRAWINGS

The above features and advantages of the present disclosure will be more apparent from the following description of some embodiments taken in conjunction with the accompanying drawings, in which:
FIG. 1 is a schematic view for explaining the configuration of a magnetic field measurement device 100 according to an embodiment of the present disclosure;
FIG. 2 is a schematic XY plan view of the sensor unit 1;
FIG. 3 is a schematic XY plan view of the sensor unit 2;
FIG. 4 is a schematic view illustrating an example of the internal structure of the magnetic sensor 10;
FIG. 5 is a schematic plan view of the sensor chip 13;
FIG. 6 is a schematic cross-sectional view taken along the line A-A in FIG. 5;
FIG. 7 is a circuit diagram of the magnetic sensor 10;
FIG. 8 is a flowchart for explaining the magnetic field measurement method using the magnetic field measurement device 100;
FIG. 9 is a schematic diagram showing the positions of the sensor units 1 and 2 when the size of the object 40 in the Z direction is large;
FIG. 10 is a schematic diagram showing the positions of the sensor units 1 and 2 when the size of the object 40 in the Z direction is small;
FIG. 11 is a schematic diagram showing the positions of the sensor units 1 and 2 when the object 40 has an inclined surface; and
FIG. 12 is a schematic diagram of a magnetic measuring device having three sensor units 1 to 3.

### DETAILED DESCRIPTION OF THE EMBODIMENTS

Some embodiments of the present disclosure will be explained below in detail with reference to the accompanying drawings.

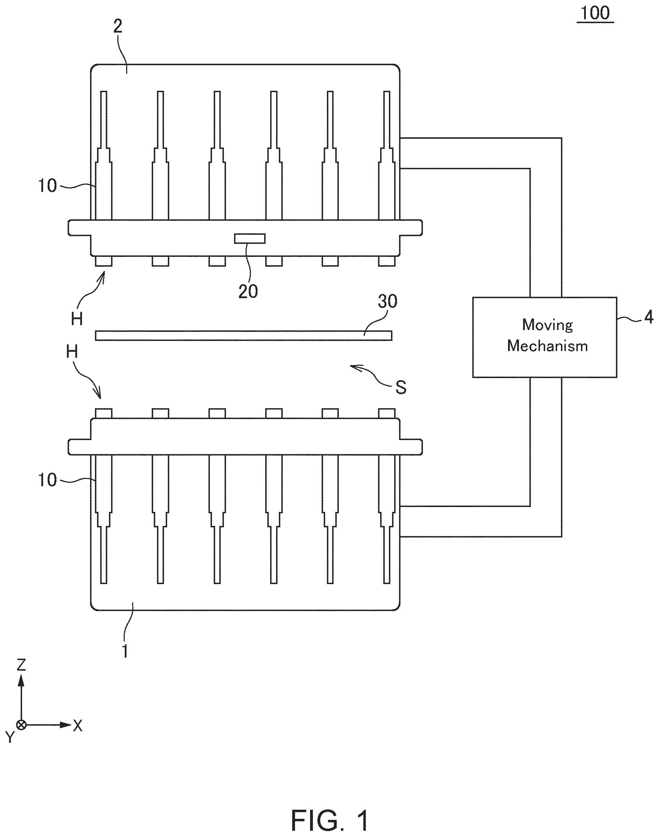

FIG. 1 is a schematic view for explaining the configuration of a magnetic field measurement device 100 according to an embodiment of the present disclosure.

As illustrated in FIG. 1, the magnetic field measurement device 100 according to the present embodiment is provided with two sensor units 1 and 2 and a moving mechanism 4 for changing the relative positional relationship between the sensor units 1 and 2. The sensor units 1 and 2 face each other in the Z-direction, and an object to be measured is disposed in a space S provided between the sensor units 1 and 2. The sensor units 1 and 2 both have a plurality of magnetic sensors 10 fixed to their housing. Thus, the relative positional relationship between the plurality of magnetic sensors 10 included in the sensor unit 1 is fixed, and the relative positional relationship between the plurality of magnetic sensors 10 included in the sensor unit 2 is fixed. The housing of the sensor unit 2 is further fixed with a magnetic field generating coil 20. Thus, in the sensor unit 2, the relative positional relationship between the plurality of magnetic sensors 10 and a magnetic field generating coil 20 is fixed.

The relative position between the sensor units 1 and 2 is changeable by the moving mechanism 4. The moving mechanism 4 may be configured to change the positions of both the sensor units 1 and 2 or configured to change the position of only one of the sensor units 1 and 2. For example, a configuration may be possible in which the sensor unit 2 is movable with respect to a stage fixed with the sensor unit 1. The moving mechanism 4 may be configured to change the Z-direction distance between the sensor units 1 and 2 and to change, in addition to or in place of this, the angles of the sensor units 1 and 2.

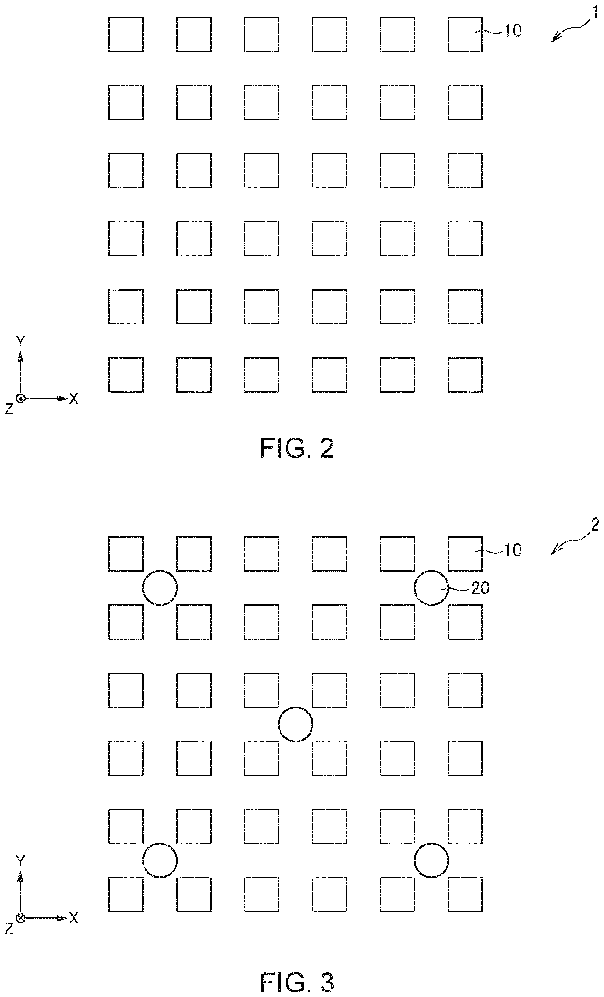

FIGS. 2 and 3 are schematic XY plan views of the respective sensor units 1 and 2.

As illustrated in FIGS. 2 and 3, the sensor units 1 and 2 each have 36 magnetic sensors 10. The 36 magnetic sensors 10 are laid out in a 6 x 6 matrix on the XY plane. The number of the magnetic sensors 10 provided in each of the sensor units 1 and 2 is not particularly limited and may be one. In the example illustrated in FIG. 3, the sensor unit 2 has five magnetic field generating coils 20. The number of the magnetic field generating coils 20 included in the sensor unit 2 is not particularly limited and may be one.

The magnetic field generating coil 20 may be a single axis coil having its axis in the Z-direction, a two-axis coil having its axes in X- and Z-directions or in Y- and Z-directions, or a three-axis coil having its axes in the X-, Y-, and Z-directions. Using a multiaxial coil as the magnetic field generating coil 20 allows reduction in the required number of the magnetic field generating coils 20. The radius, number of turns, shape of the magnetic field generating coil may be the same as or different from those of a reference magnetic field generator for calibration. Further, the waveform, frequency, and magnitude of a current to be applied to the magnetic field generating coil may be the same as or different from those for a reference magnetic field generator for calibration. As for the Z-direction, the magnetic field generating coil 20 may be disposed at a position not protruding, in a direction toward the sensor unit 1, from sensor heads H of the magnetic sensors 10 included in the sensor unit 2 to the space S, as illustrated in FIG. 1. This can bring the sensor heads H of the magnetic sensor 10 closer to an object to be measured without interference of the magnetic field generating coil 20.

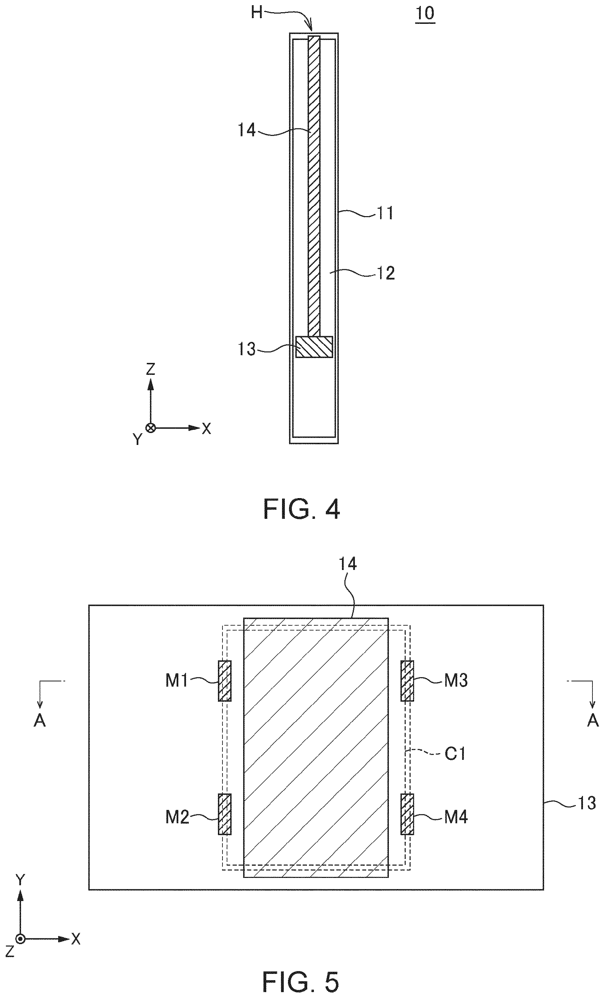

FIG. 4 is a schematic view illustrating an example of the internal structure of the magnetic sensor 10.

In the example illustrated in FIG. 4, the magnetic sensor 10 has a sensor housing body 11 made of a nonmagnetic material, a circuit substrate 12 housed in the sensor housing body 11, a sensor chip 13, and a magnetic field collecting body 14. The sensor chip 13 and magnetic field collecting body 14 are mounted on the circuit substrate 12. The magnetic field collecting body 14 has a bar-like shape elongated in the Z-direction and is made of a high permeability material such as ferrite. The XY surface of the sensor housing body 11 at which one end of the magnetic field collecting body 14 in the Z-direction is positioned constitutes the sensor head H. The sensor chip 13 is disposed at the other end of the magnetic field collecting body 14 in the Z-direction. With this configuration, a Z-direction signal magnetic field component emitted from an object to be measured positioned in the vicinity of the sensor head H is collected by the magnetic field collecting body 14 and is then applied to the sensor chip 13.

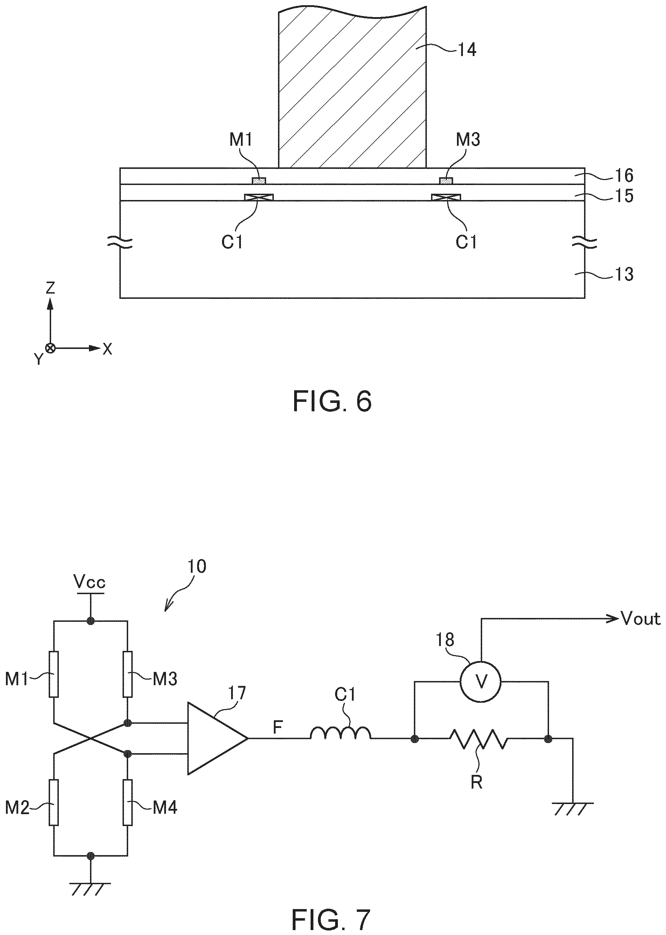

FIG. 5 is a schematic plan view of the sensor chip 13, and FIG. 6 is a schematic cross-sectional view taken along the line A-A in FIG. 5.

In the example illustrated in FIGS. 5 and 6, the sensor chip 13 has, on its element formation surface, four magnetoresistance effect elements M1 to M4 and a cancel coil C1. As the magnetoresistance effect elements M1 to M4, a GMR element, a TMR element, an AMR element, or the like may be used. Alternatively, in place of the magnetoresistance effect element, a fluxgate sensor or a Magneto-Impedance sensor may be used.

The cancel coil C1 is covered with an insulating film 15, and the magnetoresistance effect elements M1 to M4 are formed on the insulating film 15. The magnetoresistance effect elements M1 to M4 are covered with an insulating film 16. The magnetic field collecting body 14 is disposed between the magnetoresistance effect elements M1, M2 and the magnetoresistance effect elements M3, M4 as viewed in the z-direction. With this configuration, a magnetic field in the z-direction collected by the magnetic field collecting body 14 is distributed in the positive X-direction and negative X-direction on the element formation surface of the sensor chip 13. As a result, magnetic field components in mutually opposite directions are applied to the magnetoresistance effect elements M1, M2 and magnetoresistance effect elements M3, M4. The fixed magnetization directions of the magnetoresistance effect elements M1 to M4 are made uniform in the positive X-direction or negative X-direction.

The cancel coil C1 is disposed so as to overlap the magnetoresistance effect elements M1 to M4. When a cancel current is made to flow in the cancel coil C1, cancel magnetic fields in mutually opposite directions are applied to the magnetoresistance effect elements M1, M2 and the magnetoresistance effect elements M3, M4.

FIG. 7 is a circuit diagram of the magnetic sensor 10.

As illustrated in FIG. 7, the magnetoresistance effect elements M1 to M4 included in the magnetic sensor 10 are bridge-connected, and a differential signal generated thereby is supplied to a differential amplifier 17. The differential amplifier 17 generates a feedback current F based on the supplied differential signal. The feedback current F flows in the cancel coil C1. This causes the cancel coil C1 to generate a cancel magnetic field so as to make a differential signal component which is an output signal of the magnetic sensor 10 zero. The feedback current F is current-voltage converted by a resistor R. Then, a voltage measurement circuit 18 for measuring the voltage across the resistor R generates a detection signal Vout proportional to the feedback current F.

Although the above-described magnetic sensor 10 has its sensitivity axis in the Z-direction, it may be a two-axis sensor having its sensitivity axes in the X- and Z-directions or Y- and Z-directions, or may be a three-axis sensor having its sensitivity axes in the X-, Y-, and Z-directions. Using a magnetic sensor having multiple sensitivity axes as the magnetic sensor 10 allows reduction in the required number of the magnetic sensors 10.

The following describes a magnetic field measurement method using the magnetic field measurement device 100 according to the present embodiment.

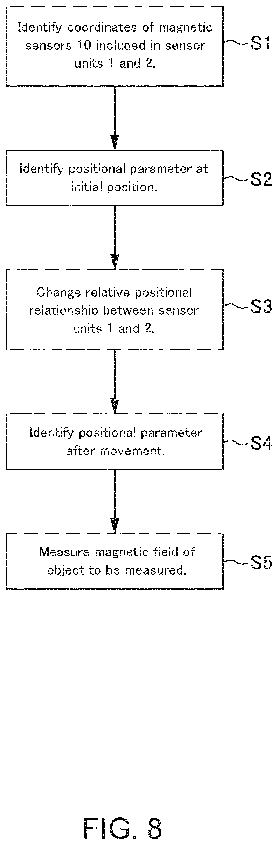

FIG. 8 is a flowchart for explaining the magnetic field measurement method using the magnetic field measurement device 100.

The coordinates of the magnetic sensors 10 included in the sensor units 1 and 2 are identified in a state where the relative position between the sensor units 1 and 2 is fixed (step S1). The above identification method is not particularly limited. For example, a method may be employed in which a calibration tool 30 is disposed in the space S as illustrated in FIG. 1 and is made to generate a magnetic field from a calibration coil provided therein, and the generated magnetic field is measured using the magnetic sensors 10 included in the sensor units 1 and 2. When the coordinates of the magnetic sensors 10 at the initial positions of the sensor units 1 and 2 are known, the coordinates of the magnetic sensors 10 may be identified by setting the sensor units 1 and 2 at their initial positions. Alternatively, the magnetic field generating coil 20 included in the sensor unit 2 may be used as the calibration coil.

Then, a current is made to flow through the magnetic field generating coil 20 included in the sensor unit 2 to generate a magnetic field, and the generated magnetic field is measured using the magnetic sensors 10 included in the sensor unit 1. This identifies a positional parameter of the sensor unit 2 at the initial position thereof as viewed from the sensor unit 1 (step S2). When the number of the magnetic field generating coils 20 included in the sensor unit 2 is one, the positional parameter includes only the distance of the sensor unit 2 from the sensor unit 1; when three or more magnetic field generating coils 20 are used, the positional parameter including the distance and angle of the sensor unit 2 from the sensor unit 1 can be obtained. When a plurality of magnetic field generating coils 20 is used, it is possible to identify the individual magnetic field generating coils 20 by generating a magnetic field in a time-division manner, or by generating magnetic fields of mutually different frequencies.

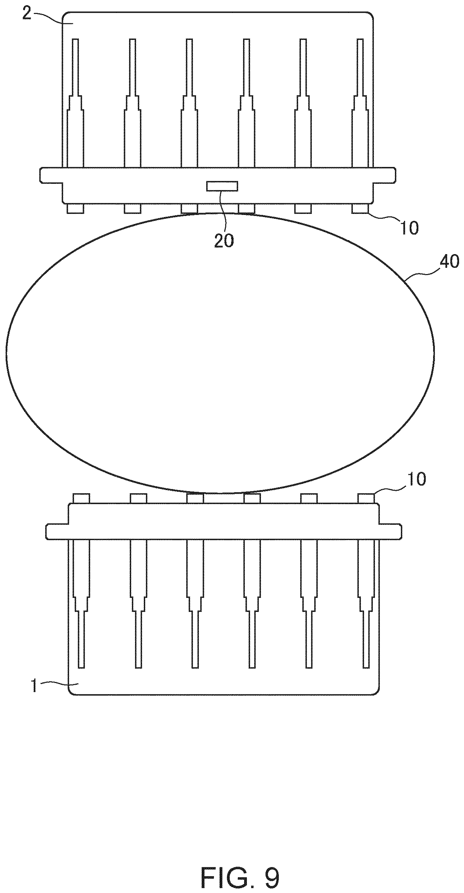

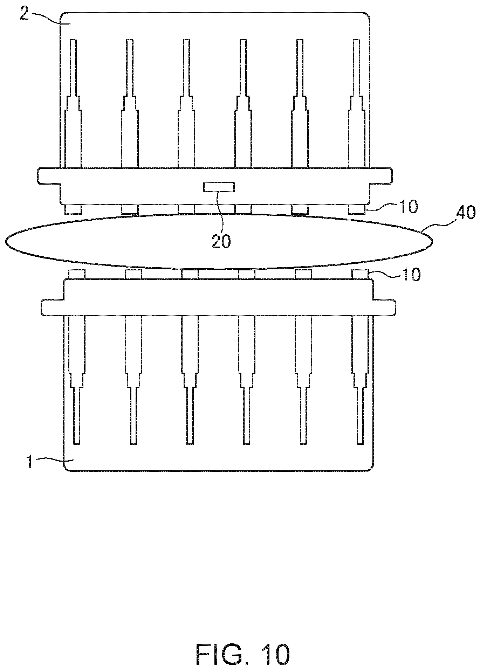

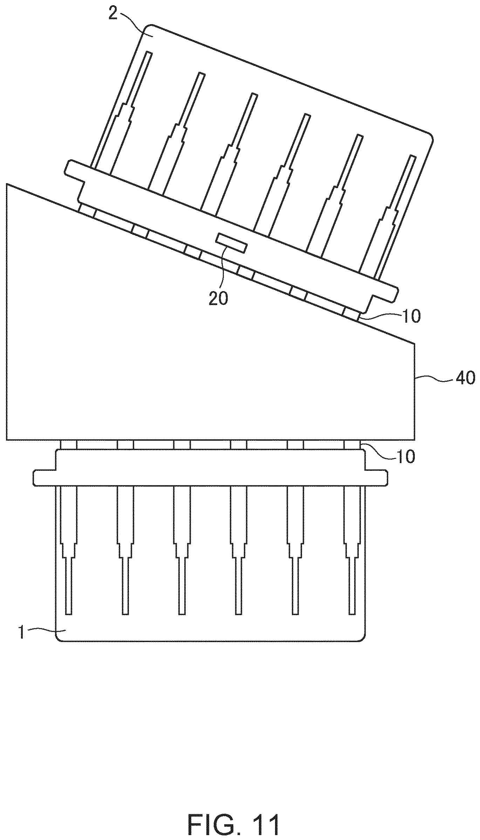

Then, an object to be measured is disposed in the space S, and the relative positional relationship between the sensor units 1 and 2 is changed in accordance with the size and shape of the object to be measured (step S3). For example, when the size of an object 40 to be measured in the Z-direction is large, the distance between the sensor units 1 and 2 in the Z-direction is increased (FIG. 9); on the other hand, when the size of an object 40 to be measured in the Z-direction is small, the distance between the sensor units 1 and 2 in the Z-direction is reduced (FIG. 10). Alternatively, the angle between the sensor units 1 and 2 may be changed depending on the shape of the object 40 to be measured (FIG. 11). This brings the sensor heads H of the magnetic sensor 10 included in the sensor units 1 and 2 closer to the object 40 to be measured.

Then, a current is made to flow again through the magnetic field generating coil 20 to generate a magnetic field, and the generated magnetic field is measured using the magnetic sensors 10 included in the sensor unit 1. Subsequently, a change amount is calculated with the positional parameter identified in step S2 set as a reference, thereby identifying a positional parameter after the change in the relative positional relationship between the sensor units 1 and 2 (step S4).

After the relative positional parameter between the sensor units 1 and 2 is thus identified, actual measurement is performed for the object 40 to be measured using the magnetic sensors 10 included in the sensor units 1 and 2 (step S5).

As described above, in the magnetic field measurement device 100 according to the present embodiment, the relative positional parameter at the initial positions of the sensor units 1 and 2 is identified, so that even when the relative positional relationship between the sensor units 1 and 2 is changed afterward, it is possible to identify, without performing additional calibration, a relative positional parameter after movement of the sensor units 1 and 2 by generating a magnetic field using the magnetic field generating coil 20.

While some embodiments of the technology according to the present disclosure have been described, the technology according to the present disclosure is not limited to the above embodiments, and various modifications may be made within the scope of the present disclosure, and all such modifications are included in the technology according to the present disclosure.

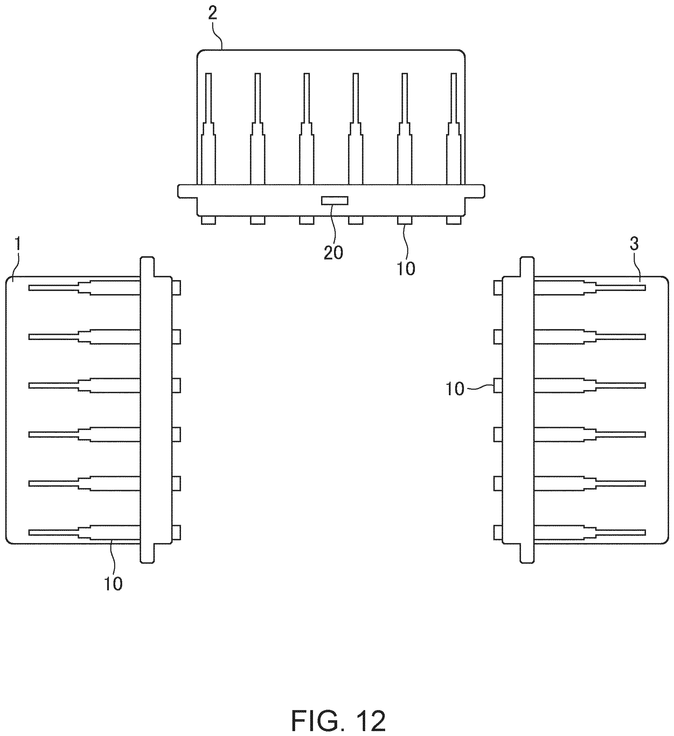

For example, although the magnetic field measurement device 100 according to the above embodiment includes the two sensor units 1 and 2, it may include three sensor units 1 to 3 as illustrated in FIG. 12. In this case, the magnetic field generating coil 20 is provided in any of the sensor units 1 to 3, whereby even when the relative positional relationship between the sensor units 1 to 3 is changed, it is possible to identify a positional parameter after the change. As a matter of course, the magnetic field measurement device 100 may include four or more sensor units.

The technology according to the present disclosure includes the following configuration examples, but not limited thereto.

A magnetic field measurement device according to an aspect of the present disclosure includes: a first sensor unit having one or more magnetic sensors; a second sensor unit having one or more magnetic sensors and one or more magnetic field generating coils; and a moving mechanism for changing the relative positional relationship between the first and second sensor units. Thus, even when the relative positional relationship between the first and second sensor units is changed using the moving mechanism, it is possible to identify a relative positional parameter between the first and second sensor units.

In the above magnetic field measurement device, the magnetic sensor included in the first sensor unit may include a plurality of magnetic sensors with fixed relative positional relationship, and the magnetic sensor included in the second sensor unit may include a plurality of magnetic sensors with fixed relative positional relationship. This allows more detailed measurement for magnetic field distribution of an object to be measured.

In the above magnetic field measurement device, the magnetic field generating coil included in the second sensor unit may include a plurality of magnetic field generating coils with fixed relative positional relationship, and the plurality of magnetic sensors included in the second sensor unit and the plurality of magnetic field generating coils included in the second sensor unit may have fixed relative positional relationship. Thus, even when the moving mechanism is configured to change the distance and angle between the first and second sensor units, the positional parameter between the first and second sensor units after the change in the relative positional relationship therebetween can be identified.

In the above magnetic field measurement device, the magnetic field generating coil may be disposed at a position not protruding from a sensor head included in the second sensor unit in a direction toward the first sensor unit. This can bring the magnetic sensors included in the second sensor unit closer to an object to be measured.

## Claims

1. A magnetic field measurement device comprising:
a first sensor unit having one or more magnetic sensors;
a second sensor unit having one or more magnetic sensors and one or more magnetic field generating coils; and
a moving mechanism configured to change a relative positional relationship between the first and second sensor units.

2. The magnetic field measurement device as claimed in claim 1,
wherein the first sensor unit includes a plurality of the magnetic sensors with fixed relative positional relationship, and
wherein the second sensor unit includes a plurality of the magnetic sensors with fixed relative positional relationship.

3. The magnetic field measurement device as claimed in claim 2,
wherein the second sensor unit includes a plurality of the magnetic field generating coils with fixed relative positional relationship, and
wherein the plurality of magnetic sensors included in the second sensor unit and the plurality of magnetic field generating coils included in the second sensor unit have fixed relative positional relationship.

4. The magnetic field measurement device as claimed in claim 3, wherein the moving mechanism is configured to change a distance and an angle between the first and second sensor units.

5. The magnetic field measurement device as claimed in any one of claims 1 to 4, wherein the magnetic field generating coil is disposed at a position not protruding from a sensor head included in the second sensor unit in a direction toward the first sensor unit.
